(19) Europäisches Patentamt / European Patent Office / Office européen des brevets

(11) **EP 3 701 252 B1**

(12) **EUROPÄISCHE PATENTSCHRIFT**

(45) Veröffentlichungstag und Bekanntmachung des Hinweises auf die Patenterteilung:
**05.07.2023  Patentblatt 2023/27**

(21) Anmeldenummer: **18770015.8**

(22) Anmeldetag: **14.09.2018**

(51) Internationale Patentklassifikation (IPC):
**G01N 24/08** $^{(2006.01)}$   **G01R 33/44** $^{(2006.01)}$
**G01R 33/38** $^{(2006.01)}$

(52) Gemeinsame Patentklassifikation (CPC):
**G01N 24/08; G01R 33/448;** G01R 33/3808

(86) Internationale Anmeldenummer:
**PCT/EP2018/074944**

(87) Internationale Veröffentlichungsnummer:
**WO 2019/081124 (02.05.2019 Gazette 2019/18)**

(54) **VERFAHREN ZUR ERMITTLUNG EINER KALIBRIERVORSCHRIFT, VERFAHREN ZUR ERMITTLUNG EINER ABSOLUTEN FEUCHTIGKEIT SOWIE NMR-MESSGERÄT**

METHOD FOR DETERMINING A CALIBRATION PROCEDURE, METHOD FOR DETERMINING ABSOLUTE HUMIDITY AND NMR MEASUREMENT DEVICE

PROCÉDÉ DE DÉTERMINATION D'UNE PROCÉDURE D'ÉTALONNAGE, PROCÉDÉ DE DÉTERMINATION DE L'HUMIDITÉ ABSOLUE ET DISPOSITIF DE MESURE DE RMN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.10.2017  DE 102017219378**

(43) Veröffentlichungstag der Anmeldung:
**02.09.2020  Patentblatt 2020/36**

(73) Patentinhaber: **Robert Bosch GmbH
70442 Stuttgart (DE)**

(72) Erfinder: **EDELMANN, Markus
70771 Leinfelden-Echterdingen (DE)**

(56) Entgegenhaltungen:
CN-A- 106 124 552   DE-A1-102014 218 375

• **A. KRATZER ET AL: "Hydration Dynamics of Durum Wheat Endosperm as Studied by Magnetic Resonance Imaging and Soaking Experiments", CEREAL CHEMISTRY, Bd. 85, Nr. 5, Oktober 2008 (2008-10), Seiten 660-666, XP055577373, US ISSN: 0009-0352, DOI: 10.1094/CCHEM-85-5-0660**
• **BERNHARD BLÜMICH ET AL: "Small-scale instrumentation for nuclear magnetic resonance of porous media", NEW JOURNAL OF PHYSICS, Bd. 13, 28. Januar 2011 (2011-01-28), Seiten 1-15, XP055577372, DOI: 10.1088/1367-2630/13/1/015003**

EP 3 701 252 B1

## Beschreibung

Stand der Technik

Die zuverlässige Bestimmung von Material- und Baufeuchte stellt einen wichtigen Aspekt im modernen Bauwesen dar. Als Referenzverfahren für eine Feuchtigkeitsbestimmung wird üblicherweise ein Trockenschrankverfahren (Darr-Verfahren) herangezogen. Das Trockenschrankverfahren beschränkt sich allerdings auf einen Laborbetrieb und ist daher nur eingeschränkt feldtauglich.

Für eine zerstörungsfreie Messung einer Feuchtigkeit eines zu untersuchenden Materials vor Ort werden derzeit insbesondere Verfahren eingesetzt, die auf dielektrischen Messungen oder auf Kernspinresonanzmessungen basieren. Um einen absoluten Wert für die Feuchtigkeit eines zu untersuchenden Materials zu erhalten, muss allerdings ein Zusammenhang zwischen einer ermittelbaren Messgröße und der Feuchtigkeit hergestellt werden. Meistens wird dabei auf eine materialspezifische Kalibriervorschrift zurückgegriffen, welche durch aufwendige Vorabmessungen, beispielsweise während einer Werkskalibrierung, bestimmt wird. Dabei wird eine Probe des Materials mit definierten Feuchtigkeiten sukzessiv vermessen, sodass ein derartiges Verfahren zur Ermittlung einer Kalibriervorschrift typischerweise mehrere Wochen dauert - insbesondere auch, da sich die Feuchtigkeit eines Materials oft nur sehr langsam einstellen lässt.

Aus DE 10 2014 218 375 A1 sind mobile NMR-Messgeräte mit einer Sensorvorrichtung bekannt, wobei die Sensorvorrichtung zumindest einen Kernspinresonanz-Sensor (NMR-Sensor) aufweist, der zur Bestimmung eines Feuchtewerts eines zu untersuchenden Materials vorgesehen ist. CN 106 124 552 A offenbart ein NMR-basiertes Verfahren zur Feuchtebestimmung auf Basis einer Kalibrierkurve, die aus Referenzproben mit bekannten Feuchtigkeitswerten ermittelt wird.

Die vorliegende Erfindung betrifft ein Verfahren zur Ermittlung einer, insbesondere materialspezifischen, Kalibriervorschrift zur Verwendung mit einem derartigen NMR-Messgerät, wobei die Kalibriervorschrift einen funktionellen Zusammenhang zwischen einer mit dem NMR-Messgerät ermittelbaren NMR-Messgröße A eines zu untersuchenden Materials und einer in dem zu untersuchenden Material enthaltenen Feuchtigkeit θ spezifiziert.

Offenbarung der Erfindung

Es wird ein Verfahren zur Ermittlung einer, insbesondere materialspezifischen, Kalibriervorschrift zur Verwendung mit einem NMR-Messgerät vorgeschlagen, wobei die Kalibriervorschrift einen funktionellen Zusammenhang zwischen einer mit dem NMR-Messgerät ermittelbaren NMR-Messgröße A eines zu untersuchenden Materials und einer in dem zu untersuchenden Material enthaltenen Feuchtigkeit θ spezifiziert. Das erfindungsgemäße Verfahren gemäss Anspruch 1 ist durch zumindest folgende Verfahrensschritte gekennzeichnet:

- Bereitstellen einer Relaxationskurve $s(t, \theta_{ref})$ des Materials, insbesondere zumindest einer Materialprobe des Materials, bekannter Feuchtigkeit $\theta_{ref}$;
- Ermitteln einer Relaxationszeitverteilung $\rho(\theta_{ref})$ aus der bereitgestellten Relaxationskurve $s(t, \theta_{ref})$;
- Ermitteln, insbesondere modellieren oder berechnen, einer approximierten Relaxationszeitverteilung $\rho(\theta_i)$ zu zumindest einer Feuchtigkeit $\theta_i$ mit $\theta_i < \theta_{ref}$;
- Rekonstruieren einer Relaxationskurve $s(t, \theta_i)$ aus der approximierten Relaxationszeitverteilung $\rho(\theta_i)$;
- Ermitteln einer zu erwartenden NMR-Messgröße A aus der rekonstruierten Relaxationskurve $s(t, \theta_i)$ bei der Feuchtigkeit $\theta_i$;
- Ermitteln der Kalibriervorschrift als Funktion θ(A) der Feuchtigkeit θ in Abhängigkeit der NMR-Messgröße A.

In einer Ausführungsform des Verfahrens können die Verfahrensschritte in der dargestellten Reihenfolge durchgeführt werden. Alternativ kann die Reihenfolge der in erfindungsgemäßem Verfahren durchgeführten Verfahrensschritte auch von der zuvor dargestellten Reihenfolge abweichen.

Unter "Ermittlung einer, insbesondere materialspezifischen, Kalibriervorschrift" ist insbesondere die Bestimmung des funktionellen Zusammenhang zwischen einer mit dem NMR-Messgerät ermittelbaren, d.h. messbaren, NMR-Messgröße A eines zu untersuchenden Materials und einer in dem zu untersuchenden Material enthaltenen Feuchtigkeit θ zu verstehen. Unter der "Kalibriervorschrift" kann dabei jegliche Form einer Zuordnung der mit dem NMR-Messgerät ermittelbaren NMR-Messgröße A zu der, die entsprechende NMR-Messgröße verursachenden, zugehörigen Feuchtigkeit θ verstanden werden. In einer Ausführungsform kann die materialspezifische Kalibriervorschrift beispielsweise in Form einer Kalibrierkurve, einer Kalibrierdatenbank, einer Kalibrierfunktion, einer Kalibriermatrix oder dergleichen realisiert sein.

Das Material ist insbesondere gegeben und festgelegt durch eine entsprechende Probe oder ein entsprechendes Werkstück des Materials. Beispielsweise kann das Material bestimmtes Holz, bestimmter Beton, ein bestimmter Baustoff oder ein bestimmtes Baustoffgemisch oder dergleichen sein.

Die "NMR-Messgröße A" bezeichnet prinzipiell jeden, einem Fachmann geläufigen Parameter, eine Größe oder einen Wert, der unter Anwendung eines NMR-Messgeräts, d.h. basierend auf einer Messung kernspinphysikalischer Effekte in dem zu untersuchenden Material, von dem zu untersuchenden Material erhalten werden kann oder aus entsprechenden Messungen abgeleitet werden kann. Unter "kernspinphysikalischer Effekt" ist dabei derjenige Effekt zu verstehen, bei dem Atomkerne in dem zu untersuchenden Material in einem ersten Magnetfeld, bezeichnet mit Bo, elektromagnetische Wechselfelder absorbieren und emittieren. Dabei beruht die Kernspinresonanz auf der Präzession (Larmorpräzession) von Kernspins der Atomkerne in dem zu untersuchenden Material um die Magnetfeldlinien des ersten, insbesondere konstanten und/oder statischen, Magnetfelds. Insbesondere werden die Kernspins der Atomkerne in einem zu untersuchenden Volumen durch das erste Magnetfeld ausgerichtet. Wird Energie in Form eines zweiten elektromagnetischen Feldes, insbesondere eines Wechselfeldes, beispielsweise eines gepulsten Magnetfeldes, auf die Atomkerne eingestrahlt, die mit der Larmorpräzession deren Kernspins in Resonanz ist (Energiequanten), so können die Atomkerne die Orientierung ihrer Spins relativ zum ersten Magnetfeld durch Absorption dieser Energie ändern. Das zweite eingestrahlte Magnetfeld dient daher der Anregung der Kernspins, die unter Energieaufnahme ihre Kernspinzustände ändern. Äquivalent führt die Emission von Energiequanten in Folge einer Rückkehr der angeregten Kernspins in ein anderes, niedrigeres Energieniveau, zur Emission eines elektromagnetischen Wechselfeldes, welches sich mittels einer Vorrichtung zur Detektion einer Magnetfeldänderung, insbesondere mittels einer Antenne und/oder einer Spule, beobachten lässt. Unter den Atomkernen sind insbesondere Protonen (H) und andere kernspinresonanz-aktive Kerne wie beispielsweise 13C, 15N, 19F, 31P zu verstehen. Beispielsweise - und nicht abschließend - kann es sich bei der NMR-Messgröße A um eine Relaxationskurve, insbesondere eine transversale Relaxationskurve oder eine longitudinale Relaxationskurve, einen Teil einer Relaxationskurve, insbesondere eine Amplitude oder eine Relaxationszeit wie eine T2-Zeit, oder dergleichen handeln. Alternativ kann die NMR-Messgröße A auch das von einer Aufbereitung (beispielsweise einer Fouriertransformation) unabhängige, physikalische NMR-Messsignal des Materials während einer NMR-Messung bezeichnen, dass sich lediglich als Resultat der chemischen Struktur in dem Material ergibt.

Unter "Feuchtigkeit $\theta$" ist insbesondere eine Konzentration verdampfbaren Wassers (zu unterscheiden von chemisch fest gebundenem Kristallwasser oder Hydratwasser) in dem zu untersuchenden Material zu verstehen. Die Feuchtigkeit $\theta$ wird dabei als absolute Feuchtigkeit $\theta$ verstanden, im Gegensatz zu einer relativen Feuchtigkeit, welche nur den Unterschied zu einem anderen Feuchtewert angibt.

In einem Verfahrensschritt des erfindungsgemäßen Verfahrens wird eine Relaxationskurve $s(t,\theta_{ref})$ des Materials, zumindest einer Materialprobe des Materials, mit bekannter Feuchtigkeit $\theta_{ref}$ bereitgestellt. Unter "bereitstellen" ist im Folgenden insbesondere zu verstehen, dass der Recheneinheit, die das erfindungsgemäße Verfahren durchführt, insbesondere der Steuervorrichtung eines NMR-Messgeräts, eine entsprechende Information oder ein Datensatz bereitgestellt wird. In einer Ausführungsform wird die Relaxationskurve $s(t,\theta_{ref})$ mittels eines NMR-Sensors eines NMR-Messgeräts gemessenen und der das erfindungsgemäße Verfahren ausführenden Recheneinheit, insbesondere der Steuervorrichtung eines NMR-Messgeräts, bereitgestellt. Beispielsweise kann eine Relaxationskurve eines Materials durch ein NMR-Messgerät typischerweise erhalten werden, wenn die in dem zu untersuchenden Material enthaltenen Kernspins in einem starken, statischen magnetischen Feld ausgerichtet und mit einem Hochfrequenz-Puls energetisch angeregt (d.h. die Kernmagnetisierung wird gedreht) werden. Anschließend wird die Hochfrequenz-Antwort des Materials als Funktion der Zeit aufgezeichnet und derart die Relaxationskurve $s(t,\theta_{ref})$ (auch bekannt als FID-Signal (free-induction-decay-Signal)) erhalten. Zusätzlich können sogenannte Spin-Echo-Techniken (insbesondere CPMG-Puls-Sequenzen) verwendet werden, um externe Einflüsse wie beispielsweise inhomogene Magnetfelder auf die Relaxation zu verhindern.

In einer Ausführungsform des erfindungsgemäßen Verfahrens wird die bereitgestellte Relaxationskurve $s(t,\theta_{ref})$ als transversale Relaxationskurve, insbesondere als T2-Relaxationskurve, bereitgestellt. Bei der transversalen Relaxationskurve wird eine T2-Zeitverteilung ermittelt, die auf eine Spin-Spin-Relaxation der Atomkerne in dem untersuchten Material zurückzuführen ist. Bei der Spin-Spin-Relaxation tauschen im allgemeinen gleichartige Spins Energie miteinander aus, sodass sich innerhalb einer charakteristischen Zeit "T2" die "Temperatur" des Spinsystems homogenisiert (sog. Spintemperatur), wobei ein Kern, der aus einem angeregten Zustand in einen Grundzustand zurückkehrt, seine Energie an einen Nachbarkern abgibt, welcher dadurch wiederum angeregt wird. In einer alternativen Ausführungsform des erfindungsgemäßen Verfahrens wird die bereitgestellte Relaxationskurve als longitudinale Relaxationskurve bereitgestellt. Bei der longitudinalen Relaxationskurve wird eine T1-Zeitverteilung ermittelt, die auf eine Spin-Gitter-Relaxation der Atomkerne in dem untersuchten Material zurückzuführen ist. Mehrere Prozesse können dabei zu der Spin-Gitter-Relaxation beitragen, u.a. magnetische Dipol-Dipol-Kopplung der Kernspins, lokale Magnetfelder durch Elektronenspins der Umgebung (chemische Verschiebung) und elektrische Quadrupolfelder (Kernquadrupolmoment). Indem die durch diese Wechselwirkungen erzeugten lokalen Magnetfelder durch die thermische Bewegung der Kerne (und damit der Variation ihrer Abstände) fluktuieren, kommt es zu charakteristischen Relaxationsprozessen.

Zum Erhalt einer Relaxationskurve $s(t,\theta_{ref})$ des Materials, wobei das Material eine bekannte Feuchtigkeit $\theta_{ref}$ aufweist, wird das Material (d.h. insbesondere eine Probe dieses Materials) auf besagte Feuchtigkeit $\theta_{ref}$ eingestellt. Dieses Einstellen auf eine Feuchtigkeit $\theta_{ref}$ kann beispielsweise unter Anwendung eines Trockenschrankverfahrens in einem Labor erfolgen. In einer Ausführungsform des Verfahrens handelt es sich bei der be-

kannten Feuchtigkeit $\theta_{ref}$ um die Sättigungsfeuchtigkeit des Materials. In einer alternativen Ausführungsform des Verfahrens beträgt die bekannte Feuchtigkeit $\theta_{ref}$ zumindest 50 %, insbesondere zumindest 70 %, ganz insbesondere zumindest 90 % der Sättigungsfeuchtigkeit des Materials.

In einer Ausführungsform lässt sich die mittels eines NMR-Messgeräts bei gegebener Feuchtigkeit $\theta_{ref}$ gemessene (oder anderweitig bereitgestellte) Relaxationskurve $s(t,\theta_{ref})$ des zu untersuchenden Materials formulieren als:

$$s\left(t, \theta_{ref}\right) = \int \rho\left(\tau, \theta_{ref}\right) \exp\left(-\frac{t}{\tau}\right) d\tau.$$

Dabei ist die Anfangsamplitude ein direktes Maß für die Spindichte und folglich für die Feuchtigkeit in dem Material, wobei $s(t = 0)\, \alpha\, \theta_{ref}$. Insbesondere stellt die Relaxationskurve eine Überlagerung vieler exponentiell abfallender Komponenten dar. Die "Relaxationszeitverteilung" gibt eine Auskunft über die Bindungsstärke und Bewegungsfreiheit von Wassermolekülen in dem untersuchten Material. Dabei ergeben sich insbesondere große Relaxationszeiten für schwach gebundene Wassermoleküle sowie für Wassermoleküle in großen Poren des Materials. Da ein zu untersuchendes Material typischerweise eine Porengrößenverteilung aufweist, folgt ebenfalls eine Verteilung der Relaxationszeiten, die der besagten Relaxationszeitverteilung entspricht. In einer Ausführungsform des erfindungsgemäßen Verfahrens wird die Relaxationszeitverteilung $\rho(\theta_{ref})$ durch inverse Laplace-Transformation aus der bereitgestellten Relaxationskurve $s(t,\theta_{ref})$ ermittelt.

Unter "ermitteln einer approximierten Relaxationszeitverteilung $\rho(\theta_i)$" ist insbesondere zu verstehen, dass, auf Grundlage der ermittelten Relaxationszeitverteilung $\rho(\theta_{ref})$, eine approximierte Relaxationszeitverteilung $\rho(\theta_i)$ zu zumindest einer Feuchtigkeit $\theta_i$ mit $\theta_i < \theta_{ref}$ abgeleitet wird, die eine tatsächlich messbare Relaxationszeitverteilung bei der entsprechenden Feuchtigkeit $\theta_i$ approximiert. Die approximierte Relaxationszeitverteilung $\rho(\theta_i)$ kann dabei auf Grundlage der ermittelten Relaxationszeitverteilung $\rho(\theta_{ref})$ modelliert oder berechnet werden oder direkt aus der ermittelten Relaxationszeitverteilung $\rho(\theta_{ref})$ durch Modifizieren oder Umrechnen dieser ermittelten Relaxationszeitverteilung $\rho(\theta_{ref})$ ermittelt werden. In einer Ausführungsform wird die approximierte Relaxationszeitverteilung $\rho(\theta_i)$ zu zumindest einer Feuchtigkeit $\theta_i$ mit $\theta_i < \theta_{ref}$ durch Multiplikation der Relaxationszeitverteilung $\rho(\theta_{ref})$ mit einer Heaviside-Stufenfunktion $H(\tau_c(\theta_i) - \tau)$ berechnet, wobei $\tau_c(\theta_i)$ derart gewählt ist, dass das Integral

$$s(\theta_i) = \int \rho(\tau, \theta_i) d\tau$$

um einen Anteil $1 - \theta_i/\theta_{ref}$ kleiner wird im Vergleich zum identischen Integral bei der Feuchtigkeit $\theta_{ref}$, d.h. zu

$$s(\theta_{ref}) = \int \rho(\tau, \theta_{ref}) d\tau .$$

Anders ausgedrückt wird $\tau_c(\theta_i)$ derart gewählt, dass das Verhältnis der Integrale $s(\theta_i)/s(\theta_{ref})$ dem Verhältnis $\theta_i/\theta_{ref}$ entspricht. In diesem "Approximationsmodell" wird die Relaxationszeitverteilung $\rho(\theta_i)$ derart reduziert, dass sukzessive große Relaxationszeiten aus dem Integral entfernt werden (Null gesetzt werden).

Das "Rekonstruieren einer approximierten Relaxationskurve $s(t,\theta_i)$" aus der approximierten Relaxationszeitverteilung $\rho(\theta_i)$ kann insbesondere unter Berechnung des Integrals

$$s(t, \theta_i) = \int \rho(t, \theta_i) \exp\left(-\frac{t}{\tau}\right) d\tau$$

erfolgen. Mit der rekonstruierten Relaxationskurve $s(t,\theta_i)$ bei der Feuchtigkeit $\theta_i$ ist es anschließend möglich, eine zu erwartende NMR-Messgröße A, insbesondere einen zu erwartenden Wert einer NMR-Messgröße, zu bestimmen. Wie bereits diskutiert, kann die NMR-Messgröße A dabei prinzipiell jeden, einem Fachmann geläufigen Parameter darstellen, der unter Anwendung eines NMR-Messgeräts, d.h. basierend auf einer Messung kernspinphysikalischer Effekte in dem zu untersuchenden Material, von dem zu untersuchenden Material erhalten werden kann oder aus entsprechenden Messungen abgeleitet werden kann. In einem Ausführungsbeispiel handelt es sich bei der zu erwartenden NMR-Messgröße A um eine Relaxationskurve oder um einen Amplitudenwert $s(0,\theta_i)$ der transversalen Relaxationskurve oder um eine Mittelung über ein bestimmtes Zeitintervall oder dergleichen.

Besagte zu erwartende NMR-Messgröße A sowie die absolute Feuchtigkeit $\theta$ - oder alternativ auch ein die Feuchtigkeit $\theta$ charakterisierender Wert (Feuchtigkeitskennwert) - wird dann in der Kalibriervorschrift als Funktion $\theta(A)$ der Feuchtigkeit $\theta$ in Abhängigkeit der ermittelbaren NMR-Messgröße A definiert. Es ist offensichtlich, dass mit zunehmender Anzahl ermittelter approximierter Relaxationszeitverteilungen $\rho(\theta_i)$ für unterschiedliche Feuchtigkeiten $\theta$ und daraus erhaltener zu erwartender NMR-Messgrößen A eine Genauigkeit der Kalibriervorschrift erhöht werden kann. In einer Ausführungsform des erfindungsgemäßen Verfahrens werden in einem weiteren Verfahrensschritt approximierte Relaxationszeitverteilungen $\rho(\theta_i)$ zu einer Mehrzahl i von Feuchtigkeiten $\theta_i$ mit $\theta_i < \theta_{ref}$ berechnet, beispielsweise zu mehr als 3, insbesondere zu mehr als 5, ganz insbesondere zu mehr als 10 Feuchtigkeiten $\theta_i$ mit $\theta_i < \theta_{ref}$. Die somit erhaltenen Feuchtigkeiten $\theta$ und zugehörigen zu erwartenden NMR-Messgrößen A werden zur Definition oder Erstellung der Kalibriervorschrift verwendet.

Es sei erwähnt, dass in einer Ausführungsform des Verfahrens die Relaxationskurve(n) vor einer Weiterverarbeitung durch bekannte Verfahren der Datenauswertung aufbereitet werden können, beispielsweise um ein verbessertes Signal-zu-Rausch-Verhältnis zu erhalten. Ferner ist es möglich, Unregelmäßigkeiten in der Relaxationskurve durch ein automatisch durchgeführtes Verfahren zu reduzieren oder zu beheben. Auch kann im Rahmen des Verfahrens eine anderweitige Datenbearbeitung erfolgen, beispielsweise im Rahmen einer Hintergrundkorrektur, eines Glättens, Filterns, Mittelns oder dergleichen.

Unter Anwendung des erfindungsgemäßen Verfahrens kann die Ermittlung einer materialspezifischen Kalibriervorschrift signifikant beschleunigt werden (bei einigen Materialien von der Größenordnung von Wochen (Stand der Technik) auf wenige Stunden). Im Gegensatz zu bisherigen Verfahren zur Ermittlung einer Kalibriervorschrift, wie sie aus dem Stand der Technik bekannt sind, wird im Rahmen des vorgeschlagenen Verfahrens nur noch eine einzige Kalibriermessung benötigt, die bei der bevorzugt hohen Feuchtigkeit $\theta_{ref}$ durchgeführt wird. Dem Verfahren liegen insbesondere Erkenntnisse über das Trocknungsverhalten von porösen Materialien zu Grunde. Ferner kann auf diese Weise der Aufbau einer Datenbank, die für unterschiedliche Materialien materialspezifische Kalibriervorschriften enthält, in vergleichsweise kurzer Zeit realisiert werden. Um die zuverlässige Bestimmung einer Feuchtigkeit $\theta$ eines zu untersuchenden Materials für eine große Bandbreite von Materialien zu ermöglichen, ist es nunmehr möglich, die zu Grunde liegende Datenbasis in Form von Kalibriervorschriften für die diversen Materialien in vertretbarer Zeit zu ermitteln.

In einer Ausführungsform des Verfahrens ist das Verfahren dazu vorgesehen, von einem NMR-Messgerät bzw. unter Verwendung eines NMR-Messgeräts ausgeführt zu werden. Ein entsprechendes NMR-Messgerät, insbesondere ein mobiles, bevorzugt handgehaltenes, NMR-Messgerät, weist dazu zumindest einen NMR-Sensor (die Begriffe "Kernspinresonanz-Sensor" und "NMR-Sensor" werden in dieser Schrift synonym verwendet) und eine Steuervorrichtung zur Steuerung des NMR-Messgeräts und zur Auswertung eines von dem Kernspinresonanz-Sensor gelieferten NMR-Messsignals auf. Entsprechend ist das NMR-Messgerät, insbesondere dessen Steuervorrichtung, zur Durchführung des erfindungsgemäßen Verfahrens zur Ermittlung einer materialspezifischen Kalibriervorschrift vorgesehen und eingerichtet.

Unter "vorgesehen" soll insbesondere speziell "programmiert", "ausgelegt" und/oder "ausgestattet" verstanden werden. Darunter, dass ein Objekt zu einer bestimmten Funktion "vorgesehen" ist, soll insbesondere verstanden werden, dass das Objekt diese bestimmte Funktion in zumindest einem Anwendungs- und/oder Betriebszustand erfüllt und/oder ausführt oder dazu ausgelegt ist, die Funktion zu erfüllen.

Ferner wird gemäss Anspruch 7 ein Verfahren zur Ermittlung einer absoluten Feuchtigkeit $\theta$ eines zu untersuchenden Materials unter Verwendung eines NMR-Messgeräts, welches nicht identisch sein muss mit dem in Anspruch 1 genannten NMR-Messgerät, vorgeschlagen. Das Verfahren umfasst zumindest die Verfahrensschritte:

- Spezifizieren eines zu untersuchenden Materials, insbesondere unter Verwendung einer Eingabevorrichtung des NMR-Messgeräts;
- Erfassen einer NMR-Messgröße A von dem zu untersuchenden Material mittels des NMR-Messgeräts;
- Bereitstellen der erfindungsgemäss ermittelten Kalibriervorschrift in Abhängigkeit des spezifizierten Materials;
- Ermitteln der absoluten Feuchtigkeit $\theta$ unter Verwendung des in der Kalibriervorschrift spezifizierten funktionellen Zusammenhangs zwischen der erfassten NMR-Messgröße A des zu untersuchenden Materials und der in dem untersuchten Material enthaltenen Feuchtigkeit $\theta$.

Es ist vorgesehen, dass das Verfahren von einem NMR-Messgerät bzw. unter Verwendung eines NMR-Messgeräts ausgeführt wird. Ein entsprechendes NMR-Messgerät, insbesondere ein mobiles, bevorzugt handgehaltenes, NMR-Messgerät, weist dazu zumindest einen NMR-Sensor (die Begriffe "Kernspinresonanz-Sensor" und "NMR-Sensor" werden in dieser Schrift synonym verwendet), eine Steuervorrichtung zur Steuerung des NMR-Messgeräts und zur Auswertung eines von dem Kernspinresonanz-Sensor gelieferten NMR-Messsignals, sowie eine Eingabevorrichtung zur Eingabe von Informationen, insbesondere zum Spezifizieren eines zu untersuchenden Materials auf. Ferner ist das NMR-Messgerät, insbesondere dessen Steuervorrichtung, zur Durchführung des erfindungsgemäßen Verfahrens zur Ermittlung einer absoluten Feuchtigkeit $\theta$ vorgesehen und eingerichtet.

Es sei an dieser Stelle angemerkt, dass das NMR-Messgerät zur Durchführung des erfindungsgemäßen Verfahrens zur Ermittlung einer materialspezifischen Kalibriervorschrift dasselbe NMR-Messgerät zur Durchführung des erfindungsgemäßen Verfahrens zur Ermittlung einer absoluten Feuchtigkeit $\theta$ eines zu untersuchenden Materials sein kann - aber nicht sein muss. Insbesondere im letzten Fall kann das Verfahren zur Ermittlung einer materialspezifischen Kalibriervorschrift auch auf einem Computer unter Verwendung eines NMR-Messgeräts (beispielsweise unter Verwendung einer sogenannten "NMR-MOUSE" ("Mobile Universal Surface Explorer")) durchgeführt werden oder auf einem Labor-NMR-Messgerät, das absolut unabhängig von einem NMR-Messgerät zur Durchführung des erfindungsgemäßen Verfahrens zur Ermittlung einer absoluten Feuchtigkeit $\theta$ eines zu untersuchenden Materials ausgeführt sein kann.

Unter "spezifizieren eines zu untersuchenden Materials" ist insbesondere zu verstehen, dass eine Information über die Art oder die Zusammensetzung des zu untersuchenden Materials der Steuervorrichtung des NMR-Messgeräts bereitgestellt wird, die das erfindungsgemäße Verfahren zur Ermittlung einer absoluten Feuchtigkeit θ durchführt. Durch das Spezifizieren des zu untersuchenden Materials kann das zu untersuchende Material von einem Anwender des erfindungsgemäßen Verfahrens entsprechend seiner vorliegenden Messbedingung fallspezifisch ausgewählt werden. Insbesondere kann das zu untersuchende Material in Folge einer Eingabe oder Auswahl durch einen Benutzer, beispielsweise mittels einer Eingabevorrichtung oder mittels einer Menüauswahl oder mittels eines Bar-Code-Scanners oder dergleichen, spezifiziert werden. Alternativ kann diese Information auch der Steuervorrichtung anderweitig bereitgestellt werden, beispielsweise durch Auslesen eines Speichers. In einer Ausführungsform kann die Information zu dem zumindest einen zu untersuchenden Material eine statische Information (dauerhaft spezifiziert) sein, d.h. in erfindungsgemäßem Verfahren wird stets unter Bezug auf das gleiche Material untersucht. Durch Spezifizierung des zu untersuchenden Materials lassen sich eine Informationsverarbeitung, insbesondere die Auswertung, vorteilhaft an das zu untersuchende Material anpassen, indem in Abhängigkeit der Spezifizierung die entsprechende materialspezifische Kalibriervorschrift gewählt werden kann. Ferner können insbesondere im Zusammenhang mit der Spezifikation ein Betriebsprogramm der Steuervorrichtung, Regelroutinen, Steuerroutinen, Auswerteroutinen und/oder Berechnungsroutinen angepasst werden.

Die in erfindungsgemäßem Verfahren zur Ermittlung einer absoluten Feuchtigkeit θ zu erfassende NMR-Messgröße A bezieht sich auf diejenige NMR-Messgröße A, die in erfindungsgemäßem Verfahren zur Ermittlung einer Kalibriervorschrift zur Ermittlung der Kalibriervorschrift als Funktion θ(A) der Feuchtigkeit θ in Abhängigkeit der ermittelbaren NMR-Messgröße A herangezogen wird. Entsprechend des bereits genannten Beispiels kann es sich dabei ebenfalls um eine Relaxationskurve, insbesondere eine transversale Relaxationskurve, einen Teil einer Relaxationskurve, insbesondere eine Amplitude oder eine Relaxationszeit wie eine T2-Zeit, oder dergleichen handeln. Alternativ kann die NMR-Messgröße A auch das von einer Aufbereitung (beispielsweise einer Fouriertransformation) unabhängige, physikalische Signal des Materials während einer NMR-Messung bezeichnen, dass sich lediglich als Resultat der chemischen Struktur in dem Material ergibt. Die zu erfassende NMR-Messgröße A wird mittels des NMR-Messgeräts ermittelt, d.h. unter Verwendung des NMR-Sensors erfasst und ggf. mittels der Steuervorrichtung analysiert.

Das Bereitstellen der, insbesondere materialspezifischen, Kalibriervorschrift erfolgt in Abhängigkeit des spezifizierten Materials. Auf diese Weise kann eine NMR-Messung auf das untersuchte Material bezogen werden und folglich eine besonders genaue Quantifizierung der im Material enthaltenen Feuchtigkeit θ ermittelt werden. Dabei kann die materialspezifische Kalibriervorschrift entweder durch Auslesen eines geräteinternen Speichers und/oder durch Übertragung der Kalibriervorschrift von einem geräteexternen Gerät, beispielsweise einem Server, einem portablen Datenverarbeitungsgerät oder dergleichen unter Verwendung einer Datenkommunikationsschnittstelle auf das NMR-Messgerät übertragen werden.

Abschließend kann, unter Verwendung der bereitgestellten Kalibriervorschrift, die absolute Feuchtigkeit θ unter Verwendung des in der Kalibriervorschrift spezifizierten funktionellen Zusammenhangs zwischen der erfassten NMR-Messgröße A und der in dem untersuchten Material gemäß Kalibriervorschrift zu erwartenden Feuchtigkeit θ ermittelt werden. Dazu muss lediglich die zu einer bestimmten NMR-Messgröße A zugehörige, d.h. gemäß Kalibriervorschrift hinterlegte oder berechenbare, Feuchtigkeit θ ermittelt werden.

In einer Ausführungsform des erfindungsgemäßen Verfahrens zur Ermittlung einer absoluten Feuchtigkeit θ wird die ermittelte absolute Feuchtigkeit θ des untersuchten Materials unter Verwendung einer Ausgabevorrichtung des NMR-Messgeräts ausgegeben. Die ausgewertete Feuchtigkeit θ kann von der Steuervorrichtung zur weiteren Verarbeitung und/oder zur Ausgabe, insbesondere zur Ausgabe an einen Benutzer des NMR-Messgeräts, mittels einer Ausgabevorrichtung und/oder zur Ausgabe an ein externes Gerät mittels einer Datenkommunikationsschnittstelle, bereitgestellt werden.

Ferner wird ein erfindungsgemäßes NMR-Messgerät, insbesondere ein handgehaltenes NMR-Messgerät, mit zumindest einem NMR-Sensor, einer Steuervorrichtung zur Steuerung des NMR-Messgeräts und zur Auswertung eines von dem NMR-Sensor gelieferten NMR-Messsignals vorgeschlagen. Die Steuervorrichtung des NMR-Messgeräts ist zur Durchführung des erfindungsgemäßen Verfahrens zur Ermittlung einer materialspezifischen Kalibriervorschrift und/oder zur Durchführung des erfindungsgemäßen Verfahrens zur Ermittlung einer absoluten Feuchtigkeit θ eines zu untersuchenden Materials vorgesehen und speziell eingerichtet.

Unter einem "handgehaltenen NMR-Messgerät" soll hier insbesondere verstanden werden, dass das NMR-Messgerät ohne Zuhilfenahme einer Transportmaschine lediglich mit den Händen, insbesondere mit einer Hand, transportiert und insbesondere auch während eines Messvorgangs an ein und/oder entlang einer zu untersuchenden Messprobe geführt werden kann. Dazu beträgt die Masse des handgehaltenen Messgeräts insbesondere weniger als 20 kg, vorteilhaft weniger als 10 kg und besonders vorteilhaft weniger als 2 kg.

In einer Ausführungsform eines handgehaltenen NMR-Messgeräts sind die Komponenten des NMR-Messgeräts, insbesondere der NMR-Sensor, die Steuervorrichtung sowie die Energieversorgungsvorrichtung des NMR-Messgeräts, zumindest teilweise in einem Gehäuse des NMR-Messgeräts untergebracht. Insbesondere sind die Komponenten in ihrem Gesamtvolumen zu mehr als 50 %, bevorzugt zu mehr als 75 % und besonders bevorzugt zu 100 % in dem Gehäuse des NMR-Messgeräts untergebracht.

In einer Ausführungsform ist das NMR-Messgerät als ein energieautonomes NMR-Messgerät realisiert. Unter "energieautonom" ist zu verstehen, dass das NMR-Messgerät zumindest vorübergehend, bevorzugt zumindest während der Durchführung einer Messung sowie einer Auswertung, unabhängig von einem Stromnetz, d.h. insbesondere kabellos, betrieben werden kann. Dazu weist das NMR-Messgerät eine Energieversorgungsvorrichtung in Form eines stromnetzunabhängigen Energiespeichers, insbesondere in Form einer Batterie, bevorzugt in Form einer wiederaufladbaren Batterie, auf. Die Energieversorgungsvorrichtung ist dazu vorgesehen, das NMR-Messgerät zur Inbetriebnahme und während des Betriebs mit elektrischer Energie zu versorgen. Der stromnetzunabhängige Energiespeicher kann in einer Ausführungsform als eine Brennstoffzelle, ein Kondensator, ein hybrider Superkondensator oder als ein anderweitiger, dem Fachmann sinnvoll erscheinender Energiespeicher oder eine Kombination/Mehrung derer realisiert sein. Insbesondere eignen sich zur Energieversorgung des NMR-Messgeräts Akkumulatoren mit einer Zellchemie, die eine hohe Leistungs- und/oder Energiedichte bereitstellt. Eine hohe Leistungs- und/oder Energiedichte erlaubt eine verbesserte, d.h. langlebigere und an einen hohen Leistungsbedarf des NMR-Sensors angepasste, Energieversorgung des NMR-Messgeräts. Dazu gehören derzeit beispielsweise Akkumulatoren der Lithium- und Lithium-Ionen-Zellchemie, insbesondere Lithium-Eisenphosphat-, Lithium-Manganoxid-, Lithium-Nickel-Cobalt-Mangan-Oxid-, überlithiierte Lithium-Nickel-Cobalt-Mangan-Oxid-, Lithium-Schwefel-, Lithium-Polymer- und Lithium-Sauerstoff-Akkumulatoren.

Das erfindungsgemäße NMR-Messgerät weist eine Steuervorrichtung zu dessen Steuerung auf. Die Steuervorrichtung ist mit den anderen Komponenten des NMR-Messgeräts, insbesondere dem NMR-Sensor, insbesondere einer Ausgabevorrichtung, der Energieversorgungsvorrichtung, ferner beispielsweise einer Eingabevorrichtung und/oder einer Datenkommunikationsschnittstelle, signaltechnisch verbunden. Die Steuervorrichtung ist dazu vorgesehen, während des Betriebs des NMR-Messgeräts mit diesen Komponenten zu kommunizieren. Unter der "Steuervorrichtung" soll insbesondere eine Vorrichtung mit zumindest einer Steuerelektronik verstanden werden, die Mittel zur Kommunikation mit den anderen Komponenten des NMR-Messgeräts, beispielsweise Mittel zur Steuerung und/oder Regelung des NMR-Sensors, Mittel zur Datenverarbeitung, Mittel zur Datenspeicherung und/oder weitere, dem Fachmann als sinnvoll erscheinende Mittel aufweist. In einer Ausführungsform ist unter der Steuerelektronik der Steuervorrichtung eine Prozessoreinheit in Verbindung mit einer Speichereinheit sowie mit einem in der Speichereinheit gespeicherten Betriebsprogramm zu verstehen, das während des Steuervorgangs ausgeführt wird. Insbesondere können die elektronischen Bauteile der Steuervorrichtung auf einer Platine (Leiterplatte) angeordnet sein, beispielsweise in Form eines Mikrokontrollers. Die Steuervorrichtung dient ferner zur Auswertung zumindest eines von dem NMR-Sensor gelieferten NMR-Messsignals, insbesondere zur Auswertung und Bereitstellung einer Relaxationskurve $s(t,\theta_{ref})$ des Materials, der Ermittlung einer Relaxationszeitverteilung $\rho(\theta_{ref})$ aus der bereitgestellten Relaxationskurve $s(t,\theta_{ref})$, der Ermittlung einer approximierten Relaxationszeitverteilung $\rho(\theta_i)$, insbesondere ausgehend und unter Verwendung der bereitgestellten Relaxationskurve $s(t,\theta_{ref})$, der Rekonstruktion einer Relaxationskurve $s(t,\theta_i)$ aus der approximierten Relaxationszeitverteilung $\rho(\theta_i)$, der Ermittlung einer zu erwartenden NMR-Messgröße A aus einer rekonstruierten Relaxationskurve $s(t,\theta_i)$ sowie der Ermittlung einer Kalibriervorschrift als Funktion $\theta(A)$ der Feuchtigkeit $\theta$ in Abhängigkeit der ermittelbaren NMR-Messgröße A. Alternativ oder zusätzlich dient die Steuervorrichtung zur Auswertung zumindest eines von dem NMR-Sensor gelieferten NMR-Messsignals, insbesondere zur Erfassung einer NMR-Messgröße A von dem zu untersuchenden Material, der Bereitstellung einer Kalibriervorschrift in Abhängigkeit eines spezifizierten Materials sowie der Ermittlung der absoluten Feuchtigkeit $\theta$ unter Verwendung des in der Kalibriervorschrift spezifizierten funktionellen Zusammenhangs. "Zur Auswertung vorgesehen" bedeutet insbesondere, dass die Steuervorrichtung einen Informationseingang zur Annahme der NMR-Messsignale, eine Informationsverarbeitungseinheit zur Bearbeitung, insbesondere Auswertung der NMR-Messsignale sowie eine Informationsausgabe zur Weitergabe der bearbeiteten und/oder ausgewerteten NMR-Messsignale, insbesondere von Relaxationskurven, Relaxationszeitverteilungen oder allgemein aus den NMR-Messsignalen ermittelte NMR-Messgrößen A, und/oder erhaltener Auswerteergebnisse aufweist. In einer Ausführungsform weist die Steuervorrichtung dazu Komponenten auf, die zumindest einen Prozessor, einen Speicher und ein Betriebsprogramm mit Auswerte- und Berechnungsroutinen umfassen. Insbesondere können diese Komponenten auch als Auswertevorrichtung bezeichnet werden und/oder als zur Steuervorrichtung separate Auswertevorrichtung ausgeführt sein.

In einer Ausführungsform des NMR-Messgeräts weist das NMR-Messgerät eine Ausgabevorrichtung zur Ausgabe von ermittelten Informationen auf. Unter einer "Ausgabevorrichtung" des NMR-Messgeräts soll zumindest ein Mittel verstanden werden, das dazu vorgesehen ist, zumindest eine wechselnde Information akustisch, optisch und/oder taktil an einen Bediener auszugeben. Die Ausgabevorrichtung dient der Ausgabe zumindest derjenigen Informationen an den Bediener des NMR-Messgeräts, die unter Verwendung des NMR-Messgeräts erhalten werden. Insbesondere kann mittels der Ausgabevorrichtung ein Ergebnis der Quantifizierung der Feuchtigkeit θ ausgegeben werden. Die Ausgabe kann dabei beispielsweise mittels eines Bildschirms, eines berührungssensitiven Bildschirms, eines Tonsignals, eines Vibrationsgebers und/oder einer LED-Anzeige realisiert werden. In einer Ausführungsform der Ausgabevorrichtung kann die Information grafisch oder alphanumerisch als Messergebnis der Untersuchung ausgegeben werden. Die Ausgabevorrichtung ist in einer Ausführungsform im Gehäuse des handgehaltenen NMR-Messgeräts untergebracht. Ferner können auszugebende Informationen oder Ergebnisse auch an die Steuervorrichtung und/oder, insbesondere zur Erhöhung des Nutzerkomforts, an ein Daten verarbeitendes System ausgegeben werden. Letzteres umfasst zumindest eine Ausgabe einer Information an ein externes Geräte wie ein Smartphone, ein Tablet-PC, ein PC sowie an ein anderes, einem Fachmann als sinnvoll erscheinendes externes Datengerät, das über eine Datenkommunikationsschnittstelle mit dem NMR-Messgerät verbunden ist. Insbesondere kann die Ausgabevorrichtung direkt im Gehäuse des NMR-Messgeräts untergebracht sein und kann zusätzlich auch über externe Ausgabevorrichtungen ergänzt werden. Unter Verwendung der mittels der Ausgabevorrichtung an einen Benutzer des NMR-Messgeräts ausgegeben Information ist es dem Benutzer des NMR-Messgeräts möglich, nach Durchführung der Quantifizierung des Analyten in der Messprobe zu einem intuitiv verständlichen Ergebnis zu gelangen.

Zur Durchführung von Messungen, insbesondere zum Messen eines NMR-Messsignals, insbesondere zur Aufnahme einer Relaxationskurve oder allgemeiner zur Aufnahme einer NMR-Messgröße A, weist das NMR-Messgerät zumindest einen NMR-Sensor auf. Die Funktionsweise des NMR-Sensors basiert auf dem bereits beschriebenen "kernspinphysikalischen" Effekt. Das erfindungsgemäße NMR-Messgerät erlaubt aus den von dem zumindest einen NMR-Sensor erhaltenen NMR-Messsignalen Informationen zu bestimmen und somit Aussagen abzuleiten, die die Feuchtigkeit θ, insbesondere die Konzentration von Wasser, und folglich den Zustand eines zu untersuchenden Materials betreffen. Zur Durchführung der Messung wird das mobile NMR-Messgerät, insbesondere der zumindest eine NMR-Sensor, nahe an die zu untersuchende Messprobe herangebracht oder umgekehrt. Die Verwendung des Messgeräts erlaubt dabei die Untersuchung der Messprobe ohne Beeinträchtigung, insbesondere ohne Zerstörung, Kontamination oder dergleichen.

Das mobile, energieautonome NMR-Messgerät stellt ein spezialisiertes Messgerät dar, das im Vergleich zu wissenschaftlichen Kernspinresonanz-Messgeräten eine stark eingeschränkte, auf die Untersuchung einer Messprobe, d.h. eines zu untersuchenden Materials, optimierte Funktionalität aufweist. Insbesondere die Steuervorrichtung mit ihren Auswerteroutinen ist auf die Durchführung des erfindungsgemäßen Verfahrens zur Ermittlung einer, insbesondere materialspezifischen, Kalibriervorschrift und/oder auf die Durchführung des erfindungsgemäßen Verfahrens zur Ermittlung einer absoluten Feuchtigkeit θ zugeschnitten. Ferner kann das NMR-Messgerät auf die Bewertung der erhaltenen Informationen sowie deren aufbereiteter Darstellung und Ausgabe mittels einer Ausgabevorrichtung zugeschnitten sein. Bei Verwendung des Messgeräts zur Untersuchung eines zu untersuchenden Materials werden die Messergebnisse für den Bediener des NMR-Messgeräts geräteintern und der Messung unmittelbar folgend aufbereitet, sodass eine schnelle, eindeutige und vor allem von weiteren Geräten wie Computern oder gar von Laboratorien unabhängige Quantifizierung der Feuchtigkeit θ in dem zu untersuchenden Material vor Ort möglich ist. Vorteilhaft ist eine einfache und intuitive Bedienung des Messgeräts erreichbar, die keine besondere Vorerfahrung des Bedieners voraussetzt.

Durch Verwendung des handgehaltenen, energieautonomen und speziell auf den Anwendungsfall der Untersuchung einer Messprobe zugeschnittenen Messgeräts ist es möglich, auf schnelle und zerstörungsfreie Weise und damit wirtschaftlich besonders kostengünstig eine präzise und umfassende Quantifizierung einer Feuchtigkeit θ in einem zu untersuchenden Material, insbesondere in einer Messprobe oder einem Werkstück, mobil vor Ort, beispielsweise auf einer Baustelle oder dergleichen, zu realisieren.

Besonders vorteilhaft erlaubt das mobile Messgerät die Bestimmung der Feuchtigkeit θ in einem Werkstück ohne Zerstörung des Werkstücks. Insbesondere handelt es sich bei dem Messverfahren um ein nicht zerstörendes, insbesondere kontaktloses Messverfahren, d.h. die Feuchtigkeit θ kann in einer Ausführungsform des erfindungsgemäßen Messgeräts auch ohne jeglichen Kontakt des Messgeräts zu der zu vermessenden Probe, gegebenenfalls auch ohne Kontakt zu dem zu untersuchenden Werkstück, erhalten werden. Das Positionieren des Messgerätes, insbesondere des darin enthaltenen Kernspinresonanz-Sensors in unmittelbarer Nähe der Werkstückoberfläche ermöglicht die Bestimmung von Feuchtewerten bis zu einer Materialtiefe von einigen Zentimeter in das Werkstück hinein.

Zeichnungen

Die Erfindung ist anhand von in den Zeichnungen dargestellten Ausführungsbeispielen in der nachfolgenden Beschreibung näher erläutert. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Gleiche oder ähnliche Bezugszeichen in den Figuren bezeichnen gleiche oder ähnliche Elemente.

Es zeigen:

Figur 1      eine perspektivische Darstellung einer Ausgestaltung des erfindungsgemäßen mobilen NMR-Messgeräts,

Figur 2     eine Draufsicht auf eine erste Gehäuseseite einer Ausgestaltung des erfindungsgemäßen NMR-Messgeräts,

Figur 3     ein Verfahrensdiagramm einer Ausführungsform des erfindungsgemäßen Verfahrens zur Ermittlung einer Kalibriervorschrift,

Figur 4a     eine beispielhafte Relaxationskurve $s(t, \theta_{ref})$ bei der Feuchtigkeit $\theta_{ref}$,

Figur 4b     eine für die in Figur 4a dargestellte Relaxationskurve $s(t, \theta_{ref})$ berechnete Relaxationszeitverteilung $\rho(\theta_{ref})$,

Figur 4c,d     jeweils eine aus der in Figur 4b dargestellten Relaxationszeitverteilung $\rho(\theta_{ref})$ durch Multiplikation mit einer Heaviside-Stufenfunktion $H(\tau_c(\theta) - \tau)$ berechnete approximierte Relaxationszeitverteilung $\rho(\theta_1)$ bzw. $\rho(\theta_5)$,

Figur 4e     jeweils eine rekonstruierte Relaxationskurve $s(t, \theta_1)$ und $s(t, \theta_5)$ zu den in Figur 4c,d dargestellten Relaxationszeitverteilungen $\rho(\theta_1)$ bzw. $\rho(\theta_5)$,

Figur 5     ein Verfahrensdiagramm einer Ausführungsform des erfindungsgemäßen Verfahrens zur Ermittlung einer absoluten Feuchtigkeit eines zu untersuchenden Materials.

Beschreibung der Ausführungsbeispiele

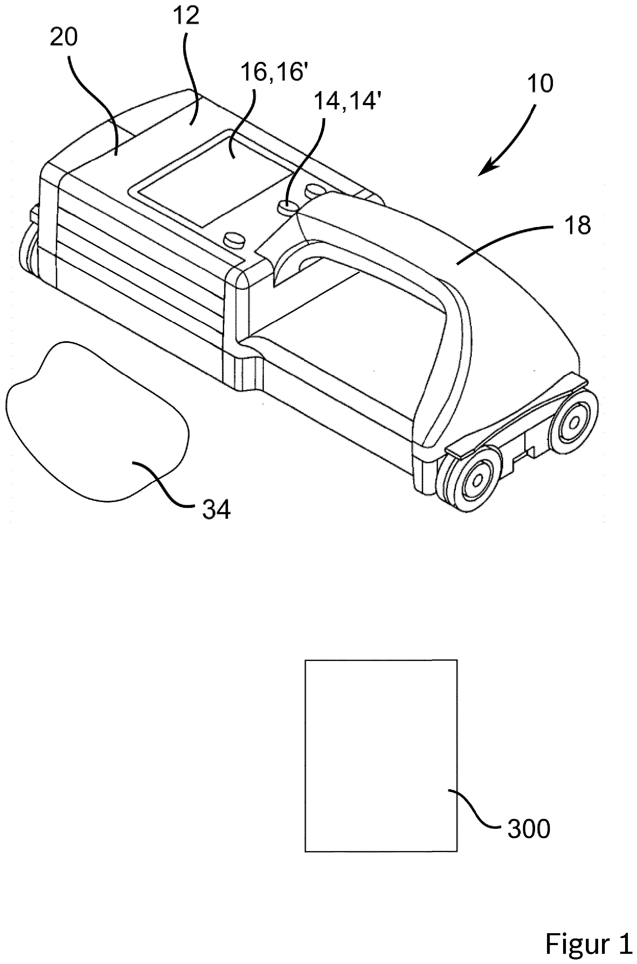

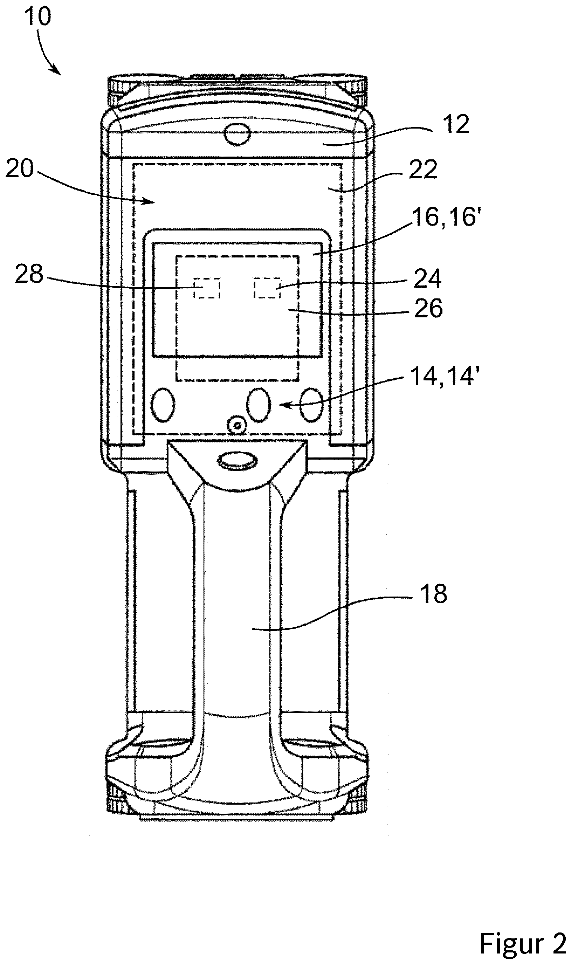

Figur 1 und Figur 2 zeigen zwei Ansichten einer beispielhaften Ausführungsform des erfindungsgemäßen handgehaltenen, energieautonomen NMR-Messgeräts 10 in perspektivischer Darstellung bzw. in vereinfachter, schematischer Aufsicht.

Das beispielhaft ausgeführte NMR-Messgerät 10 weist ein Gehäuse 12 auf. In dem Gehäuse 12 ist eine Eingabevorrichtung 14 in Form von Betätigungselementen 14', geeignet zum Ein- und Ausschalten des NMR-Messgeräts 10, zum Starten und Konfigurieren eines Messvorgangs und zum Eingeben von Arbeitsparametern, untergebracht. Ferner ist in dem Gehäuse 12 eine Ausgabevorrichtung 16 zur Ausgabe von ermittelten Informationen sowie zur Ausgabe von Arbeitsparametern in Form eines Bildschirm 16' vorgesehen. Das NMR-Messgerät 10 verfügt zum Transport und zu dessen Führung über einen Handgriff 18. Der Handgriff 18, die Betätigungselemente 14' sowie der Bildschirm 16' befinden sich auf einer ersten Gehäuseseite 20 des NMR-Messgeräts 10 (auch "Frontseite"), die bei einer Bedienung des NMR-Messgeräts typischerweise dem Bediener zugewandt ist.

Zur Energieversorgung des NMR-Messgerät 10 weist das NMR-Messgerät 10 auf der, der ersten Gehäuseseite 20 geräterückseitig gegenüberliegenden, zweiten Gehäuseseite (hier nicht näher dargestellt) eine Aussparung auf, die der Aufnahme von stromnetzunabhängigen Energiespeichern (hier nicht näher dargestellt) in Form von wiederaufladbaren Akkus dient. Auf Grund des stromnetzunabhängigen Energiespeichers kann das NMR-Messgerät 10 zumindest vorübergehend energieautonom, d.h. unabhängig von einem Stromnetz und somit insbesondere auch kabellos, betrieben werden. Das beispielhaft vorgestellte NMR-Messgerät 10 besitzt Lithium-Ionen-Akkus, deren hohe Energie- und Leistungsdichte vorteilhaft zur Energieversorgung des NMR-Messgeräts 10 geeignet ist. Vorzugsweise weist die Energieversorgungsvorrichtung eine lösbare Formschluss- und/oder Kraftschlussverbindungsschnittstelle auf, sodass der Energiespeicher (im Allgemeinen auch mehrere) abnehmbar und austauschbar anordenbar ist. Darüber hinaus lässt sich der Energiespeicher in und/oder außerhalb des NMR-Messgeräts 10 mit Energie aus einem Stromnetz versorgen und laden.

Auf einem Trägerelement 22, insbesondere einer Systemplatine oder Leiterplatte innerhalb des Gehäuses 12, sind weitere Komponenten des NMR-Messgeräts 10, insbesondere ein NMR-Sensor 24, eine Steuervorrichtung 26 zur Steuerung des NMR-Messgeräts 10 und zur Auswertung von von dem NMR-Sensor 24 gelieferten NMR-Messsignalen, sowie eine mit der Steuervorrichtung 26 verbundene Datenkommunikationsschnittstelle 28, untergebracht (siehe insbesondere Figur 2). Die Steuervorrichtung 26 ist zur Durchführung der zwei vorgeschlagenen erfindungsgemäßen Verfahren vorgesehen und weist dazu einen Speicher mit einem darauf gespeicherten und ausführbaren Betriebsprogramm auf. Insbesondere dient die Steuervorrichtung 26 zur Auswertung zumindest eines von dem NMR-Sensor 24 gelieferten NMR-Messsignals, insbesondere zur Auswertung und Bereitstellung einer Relaxationskurve $s(t, \theta_{ref})$ eines Materials 34, der Ermittlung einer Relaxationszeitverteilung $\rho(\theta_{ref})$ aus der bereitgestellten Relaxationskurve $s(t, \theta_{ref})$, der Ermittlung einer approximierten Relaxationszeitverteilung $\rho(\theta_i)$, insbesondere ausgehend und unter Verwendung der bereitgestellten Relaxationszeitverteilung $\rho(\theta_{ref})$, der Rekonstruktion einer Relaxationskurve $s(t, \theta_i)$ aus der approximierten Relaxationszeitverteilung $\rho(\theta_i)$, der Ermittlung einer zu erwartenden NMR-Messgröße A aus einer rekonstruierten Relaxationskurve $s(t, \theta_i)$ sowie der Ermittlung einer Kalibriervorschrift als Funktion $\theta(A)$ der Feuchtigkeit $\theta$ in Abhängigkeit einer (mittels des NMR-Messgeräts 10) ermittelbaren NMR-Messgröße A.

Zusätzlich dient die Steuervorrichtung 26 zur Auswertung zumindest eines von dem NMR-Sensor 24 gelieferten NMR-Messsignals, insbesondere zur Erfassung einer NMR-Messgröße A von dem zu untersuchenden Material 34, der Bereitstellung einer Kalibriervorschrift in Abhängigkeit eines spezifizierten Materials 34 sowie der Ermittlung der absoluten Feuchtigkeit $\theta$ unter Verwendung des in der Kalibriervorschrift spezifizierten funktionellen Zusammenhangs.

In einem alternativen Ausführungsbeispiel kann die Steuervorrichtung 26 auch nur zur Durchführung eines der zwei vorgeschlagenen Verfahren, d.h.

entweder zur Durchführung des Verfahrens zur Ermittlung einer Kalibriervorschrift oder zur Durchführung des Verfahrens zur Ermittlung einer absoluten Feuchtigkeit θ eines zu untersuchenden Materials 34 vorgesehen sein.

Die Steuervorrichtung 26 weist eine Steuerelektronik umfassend Mittel zur Kommunikation mit den anderen Komponenten des NMR-Messgeräts 10 auf, beispielsweise Mittel zur Steuerung und Regelung des NMR-Sensors 24, einer von der Steuervorrichtung 26 unabhängigen Auswertevorrichtung, einer Datenkommunikationsschnittstelle 28 oder dergleichen. Die Steuervorrichtung 26 umfasst insbesondere eine Einheit mit einer Prozessoreinheit, einer Speichereinheit und einem in der Speichereinheit gespeicherten Betriebsprogramm. Die Steuervorrichtung 26 ist dazu vorgesehen, zumindest ein Betriebsfunktionsparameter des NMR-Messgeräts 10 in Abhängigkeit von zumindest einer Eingabe durch einen Bediener, durch eine ggf. vorgesehene Auswertevorrichtung und/oder durch die Datenkommunikationsschnittstelle 28 einzustellen.

Der NMR-Sensor 24 ist zur Anregung einer Kernspinresonanz in Atomkernen des zu untersuchenden Materials 34 vorgesehen. Der NMR-Sensor 24 ist insbesondere zum Messen eines NMR-Messsignals, insbesondere einer Relaxationskurve $s(t, \theta_i)$, vorgesehen.

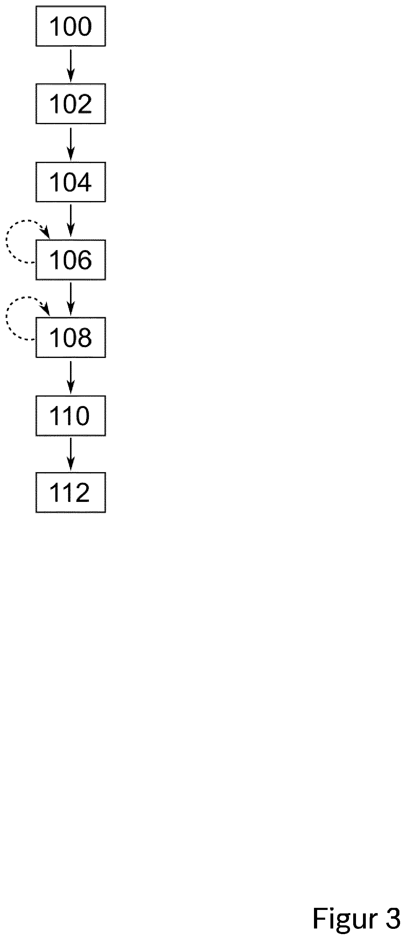

In der Figur 3 ist ein Verfahrensdiagramm gezeigt, dass ein Ausführungsbeispiel des erfindungsgemäßen Verfahrens zur Ermittlung einer, insbesondere materialspezifischen, Kalibriervorschrift wiedergibt, wobei die Kalibriervorschrift einen funktionellen Zusammenhang zwischen einer mit dem NMR-Messgerät 10 ermittelbaren NMR-Messgröße A eines zu untersuchenden Materials 34 und einer in dem zu untersuchenden Material 34 enthaltenen Feuchtigkeit θ spezifiziert.

In Verfahrensschritt 100 wird das Material 34, zu dem eine entsprechende Kalibriervorschrift ermittelt werden soll, auf eine bekannte Feuchtigkeit $\theta_{ref}$ eingestellt. Dieser Verfahrensschritt wird beispielsweise unter Verwendung eines Trockenschranks realisiert. In einem Ausführungsbeispiel kann die Feuchtigkeit $\theta_{ref}$ beispielsweise 100 % der Sättigungsfeuchtigkeit des Materials 34 betragen.

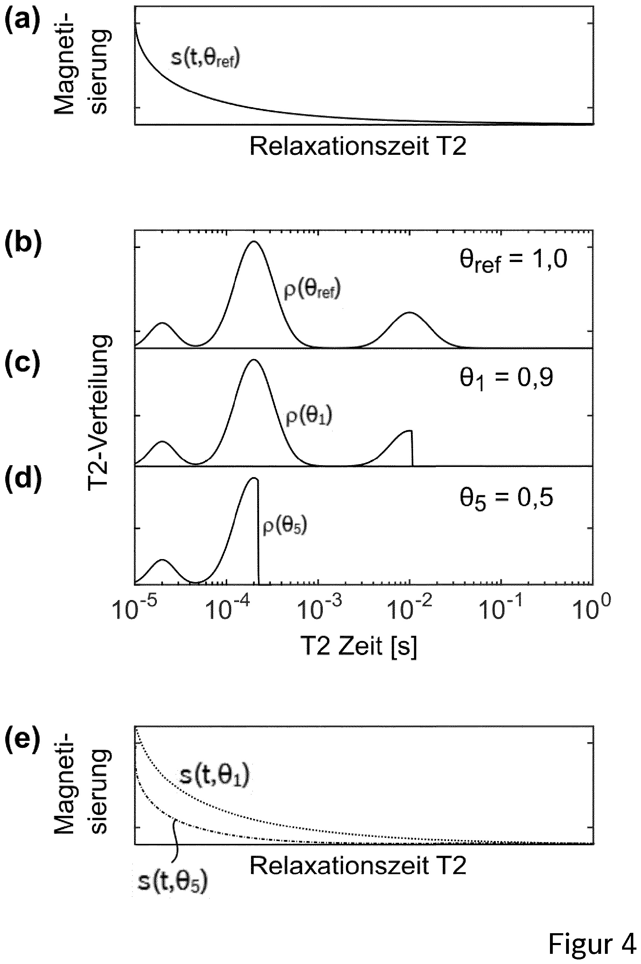

In Verfahrensschritt 102 wird, insbesondere mit einem NMR-Sensors 24 eines NMR-Messgeräts 10, ein NMR-Messsignal erfasst und daraus eine Relaxationskurve $s(t, \theta_{ref})$ ermittelt. Diese Relaxationskurve $s(t, \theta_{ref})$ wird anschließend einer Recheneinheit des das Verfahren ausführenden Geräts, insbesondere der Steuervorrichtung 26 des NMR-Messgeräts 10, bereitgestellt. Das NMR-Messsignal, insbesondere die zu Grunde liegenden Daten, kann ferner zur Auswertung vorbereitet werden, beispielsweise durch Glätten, Filtern oder dergleichen. Eine beispielhafte Relaxationskurve $s(t, \theta_{ref})$ ist in Figur 4a dargestellt.

In Verfahrensschritt 104 wird aus der bereitgestellten Relaxationskurve $s(t, \theta_{ref})$ eine Relaxationszeitverteilung $\rho(\theta_{ref})$ durch inverse Laplace-Transformation ermittelt, insbesondere berechnet. Eine für die in Figur 4a dargestellte Relaxationskurve $s(t, \theta_{ref})$ berechnete Relaxationszeitverteilung $\rho(\theta_{ref})$ ist in Figur 4b dargestellt.

In Verfahrensschritt 106 wird eine approximierte Relaxationszeitverteilung $\rho(\theta_i)$ zu zumindest einer Feuchtigkeit $\theta_i$ mit $\theta_i < \theta_{ref}$ durch Multiplikation der Relaxationszeitverteilung $\rho(\theta_{ref})$ mit einer Heaviside-Stufenfunktion $H(\tau_c(\theta) - \tau)$ berechnet, wobei $\tau_c(\theta)$ derart gewählt ist, dass ein Integral

$$s(\theta_i) = \int \rho(\tau, \theta_i)d\tau$$

um einen Anteil $1 - \theta_i/\theta_{ref}$ kleiner wird im Vergleich zum identischen Integral bei der Feuchtigkeit $\theta_{ref}$, d.h. zu

$$s(\theta_{ref}) = \int \rho(\tau, \theta_{ref})d\tau \; .$$

Dieser Verfahrensschritt 106 kann in einer Ausführungsform des Verfahrens mehrfach wiederholt werden - im Verfahrensdiagramm in Figur 4 durch einen gestrichelten Wiederholungspfeil angedeutet -, sodass nach vollständigem Abschluss von Verfahrensschritt 106 approximierte Relaxationszeitverteilungen $\rho(\theta_i)$ zu einer Mehrzahl i von Feuchtigkeiten $\theta_i$ mit $\theta_i < \theta_{ref}$ berechnet vorliegen. In einem Ausführungsbeispiel beträgt i beispielsweise 9, d.h. mit der aus der bereitgestellten Relaxationskurve $s(t, \theta_{ref})$ berechneten Relaxationszeitverteilung $\rho(\theta_{ref})$ liegen insgesamt 10 Relaxationszeitverteilungen $\rho(\theta_{ref})$, $\rho(\theta_1)$, ..., $\rho(\theta_9)$ vor. In Figuren 4c und 4d sind jeweils eine beispielhafte, aus der in Figur 4b berechneten Relaxationszeitverteilung $\rho(\theta_{ref})$ durch Multiplikation mit einer Heaviside-Stufenfunktion $H(\tau_c(\theta) - \tau)$ berechnete, approximierte Relaxationszeitverteilungen $\rho(\theta_1)$ und $\rho(\theta_5)$ dargestellt. Dabei beträgt $\theta_1 = 0,9$ (entsprechend 90 % der Sättigungsfeuchtigkeit des Materials 34) und $\theta_5 = 0,5$ (entsprechend 50 % der Sättigungsfeuchtigkeit des Materials 34), sodass entsprechend $\tau_c(\theta_1)$ und $\tau_c(\theta_5)$ derart gewählt sind, dass das Integral

$$s(\theta) = \int \rho(\tau, \theta)d\tau$$

um einen Anteil 0,1 bzw. um 0,5 kleiner ist als

$$s(\theta_{ref}) = \int \rho(\tau, \theta_{ref})d\tau \; .$$

In dem dargestellten Graphen entspricht die Verringerung des Integrals einer Reduktion der Fläche unter der Relaxationszeitverteilung um den entsprechenden Anteil 0,1 (um 10 %) bzw. 0,5 (um 50 %).

In Verfahrensschritt 108 wird aus der jeweiligen approximierten Relaxationszeitverteilung $\rho(\theta_i)$ eine Relaxationskurve $s(t, \theta_i)$ rekonstruiert, sodass auch dieser Verfahrensschritt 108 mehrfach wiederholt wird - im Verfahrensdiagramm in Figur 4 durch einen gestrichelten Wiederholungspfeil angedeutet. Für die zwei beispielhaften Feuchtigkeiten $\theta_1$ und $\theta_5$ sind zwei beispielhafte Relaxationskurven $s(t,\theta_1)$ und $s(t,\theta_5)$ in Figur 4e dargestellt. Aus den somit erhaltenen Relaxationskurven $s(t,\theta_i)$, hier im Beispiel der Figur 4 $s(t,\theta_1)$ und $s(t,\theta_5)$, werden anschließend in Verfahrensschritt 110 zu erwartende NMR-Messgrößen $A_i$, d.h. hier im Beispiel $A_1$ bzw. $A_5$, ermittelt. Die NMR-Messgröße $A_i$ wird dabei in diesem Ausführungsbeispiel als Amplitude $s(0,\theta_i)$ der jeweiligen Relaxationskurve $s(t,\theta_i)$ definiert. Alternativ oder zusätzlich kann auch die Relaxationskurve $s(t,\theta_i)$ selbst bereits als NMR-Messgröße A interpretiert und verwendet werden.

In Verfahrensschritt 112 wird unter Verwendung der ermittelten, zu erwartenden, NMR-Messgrößen $A_i$, der NMR-Messgröße $A_{ref}$ zur Feuchtigkeit $\theta_{ref}$ sowie den entsprechenden Feuchtigkeiten $\theta_i$ und $\theta_{ref}$ die Kalibriervorschrift als Funktion $\theta(A)$ der Feuchtigkeit $\theta$ in Abhängigkeit der ermittelbaren NMR-Messgröße A ermittelt. In dem Ausführungsbeispiel der Figur 4 werden die 10 Feuchtigkeiten $\theta_1$, ..., $\theta_9$, $\theta_{ref}$ in einer Zuordnungstabelle oder einer Kalibrierkurve als Kalibriervorschrift in Abhängigkeit von der NMR-Messgröße $A_1$, ..., $A_9$ und $A_{ref}$ hinterlegt. Im Anwendungsfall, d.h. bei Durchführung des Verfahrens zur Ermittlung einer absoluten Feuchtigkeit $\theta$ eines zu untersuchenden Materials 34 unter Verwendung eines NMR-Messgeräts 10, kann somit eine aus einer NMR-Messung ausgewertete NMR-Messgröße A zur Ermittlung der Feuchtigkeit $\theta$ verwendet werden, indem der Wert der zugehörigen Feuchtigkeit $\theta$ unter Anwendung der Kalibriervorschrift ausgelesen, interpoliert oder berechnet wird.

Prinzipiell kann das erfindungsgemäße Verfahren zur Ermittlung einer, insbesondere materialspezifischen, Kalibriervorschrift für unterschiedliche Materialien 34 durchgeführt werden und auf diese Weise eine Materialdatenbank aufgebaut werden, in der eine Vielzahl von materialspezifischen Kalibriervorschrift vorgehalten werden.

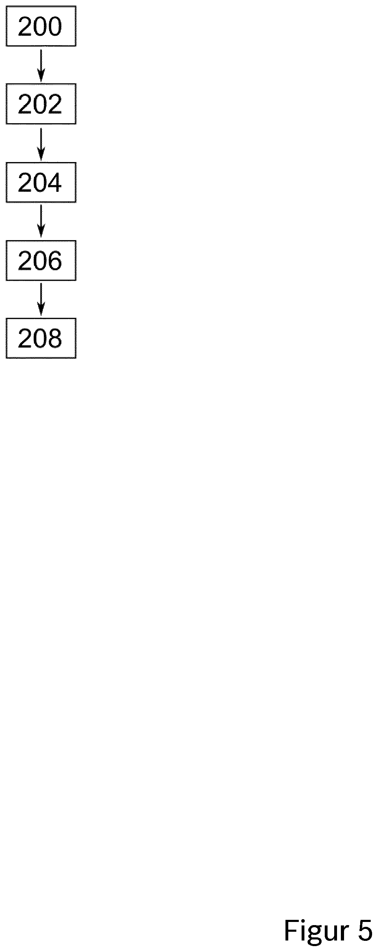

In der Figur 5 ist ein Verfahrensdiagramm gezeigt, dass ein Ausführungsbeispiel des erfindungsgemäßen Verfahrens zur Ermittlung einer absoluten Feuchtigkeit $\theta$ eines zu untersuchenden Materials 34 unter Verwendung eines NMR-Messgeräts 10 wiedergibt.

In einem Verfahrensschritt 200 wird zunächst ein zu untersuchendes Material unter Verwendung einer Eingabevorrichtung 14 des verwendeten NMR-Messgeräts 10 spezifiziert, beispielsweise in Folge einer Eingabe oder Auswahl durch einen Benutzer. In einem Ausführungsbeispiel gibt der Benutzer das zu untersuchende Material 34 explizit an, indem er beispielsweise den Namen des Materials "Beton-Estrich" (beispielsweise aus einer vorgegebenen Liste) auswählt.

In Verfahrensschritt 202 wird - ausgehend von dem spezifizierten Namen des Materials 34 - eine Kalibriervorschrift in Abhängigkeit des spezifizierten Materials 34 bereitgestellt, insbesondere der Steuervorrichtung 26 des NMR-Messgeräts 10 bereitgestellt. Die Kalibriervorschrift zu dem zu untersuchenden Material 34 wird in diesem Ausführungsbeispiel durch eine Datenbankabfrage, insbesondere unter Verwendung einer Internetverbindung, bereitgestellt. Die von einer Datenbank 300 (vgl. Figur 1) mittels der Datenkommunikationsschnittstelle 28 des NMR-Messgeräts 10 abgerufene Kalibriervorschrift wird an die Steuervorrichtung 26 weitergeleitet.

In Verfahrensschritt 204 wird eine NMR-Messgröße A von dem zu untersuchenden Material 34 mittels des NMR-Messgeräts 10 erfasst. Insbesondere wird dabei mit dem NMR-Sensor 24 des NMR-Messgeräts 10 ein NMR-Messsignal erfasst und daraus eine Relaxationskurve $s(t,\theta)$ ermittelt. Diese Relaxationskurve $s(t,\theta)$ wird anschließend der Steuervorrichtung 26 des NMR-Messgeräts 10 bereitgestellt und daraus die zur Identifizierung einer Zuordnung in der Kalibriervorschrift benötigte NMR-Messgröße A, in Analogie zur Beschreibung des Verfahrens in Figur 4 hier als Amplitude $s(0,\theta)$ definiert, ermittelt.

In Verfahrensschritt 206 wird anschließend die absolute Feuchtigkeit $\theta$ unter Verwendung des in der Kalibriervorschrift spezifizierten funktionellen Zusammenhangs zwischen der NMR-Messgröße A des untersuchten Materials 34 und der in dem untersuchten Material 34 zu erwartenden Feuchtigkeit $\theta$ ermittelt.

In Verfahrensschritt 208 wird das Ergebnisse der Quantifizierung der absoluten Feuchtigkeit $\theta$ mittels der Steuervorrichtung 26 des NMR-Messgeräts 10 weiter verarbeitet, insbesondere mittels der Ausgabevorrichtung 16 des NMR-Messgeräts 10 an einen Bediener des NMR-Messgeräts 10 ausgegeben. In dieser Ausführungsform wird ein Prozentwert ausgegeben, der die Konzentration der absoluten Feuchtigkeit $\theta$ in dem Material angibt.

**Patentansprüche**

1. Verfahren zur Ermittlung einer Kalibriervorschrift zur Verwendung mit einem NMR-Messgerät (10), wobei die Kalibriervorschrift einen funktionellen Zusammenhang zwischen einer mit dem NMR-Messgerät (10) ermittelbaren NMR-Messgröße A eines zu untersuchenden Materials (34) und einer in dem zu untersuchenden Material (34) enthaltenen Feuchtigkeit $\theta$ spezifiziert, **gekennzeichnet durch** zumindest die folgenden von dem NMR-Messgerät (10) oder auf einem Computer durchgeführten Verfahrensschritte

   • Bereitstellen einer Relaxationskurve $s(t,\theta_{ref})$ des Materials (34) bekannter Feuchtigkeit $\theta_{ref}$;
   • Ermitteln einer Relaxationszeitverteilung $\rho(\theta_{ref})$ aus der bereitgestellten Relaxationskurve $s(t,\theta_{ref})$;
   • Ermitteln einer approximierten Relaxationszeitverteilung $\rho(\theta_i)$ zu zumindest einer Feuchtigkeit $\theta_i$ mit $\theta_i < \theta_{ref}$;

• Rekonstruieren einer Relaxationskurve $s(t,\theta_i)$ aus der approximierten Relaxationszeitverteilung $\rho(\theta_i)$;
• Ermitteln einer zu erwartenden NMR-Messgröße $A_i$ aus der rekonstruierten Relaxationskurve $s(t,\theta_i)$ bei der Feuchtigkeit $\theta_i$;
• Ermitteln der Kalibriervorschrift als Funktion $\theta(A)$ der Feuchtigkeit $\theta$ in Abhängigkeit der NMR-Messgröße A.

2. Verfahren nach Anspruch 1, **dadurch gekennzeichnet, dass** die bereitgestellte Relaxationskurve $s(t,\theta_{ref})$ als transversale Relaxationskurve bereitgestellt wird.

3. Verfahren nach einem der vorhergehenden Ansprüche, **dadurch gekennzeichnet, dass** die bekannte Feuchtigkeit $\theta_{ref}$ zumindest 50 % beträgt, bevorzugt zumindest 70 % beträgt, besonders bevorzugt zumindest 90 % einer Sättigungsfeuchtigkeit des Materials (34) beträgt.

4. Verfahren nach einem der vorhergehenden Ansprüche, **dadurch gekennzeichnet, dass** die Relaxationszeitverteilung $\rho(\theta_{ref})$ durch inverse Laplace-Transformation aus der bereitgestellten Relaxationskurve $s(t,\theta_{ref})$ ermittelt wird.

5. Verfahren nach einem der vorhergehenden Ansprüche, **dadurch gekennzeichnet, dass** die approximierte Relaxationszeitverteilung $\rho(\theta_i)$ zu zumindest einer Feuchtigkeit $\theta_i$ mit $\theta_i < \theta_{ref}$ durch Multiplikation der Relaxationszeitverteilung $\rho(\theta_{ref})$ mit einer Heaviside-Stufenfunktion $H(\tau_c(\theta_i) - \tau)$ berechnet wird, wobei $\tau_c(\theta_i)$ derart gewählt ist, dass ein Integral $s(\theta_i) = \int\rho(\tau,\theta_i)dt$ um einen Anteil $1 - \theta/\theta_{ref}$ kleiner wird als $s(t,\theta_{ref})$.

6. Verfahren nach einem der vorhergehenden Ansprüche, **dadurch gekennzeichnet, dass** in einem weiteren Verfahrensschritt approximierte Relaxationszeitverteilungen $\rho(\theta_i)$ zu einer Mehrzahl i von Feuchtigkeiten $\theta_i$ mit $\theta_i < \theta_{ref}$ berechnet werden, insbesondere zu mehr als 3, bevorzugt zu mehr als 5, besonders bevorzugt zu mehr als 10 Feuchtigkeiten $\theta_i$ mit $\theta_i < \theta_{ref}$ berechnet werden.

7. Verfahren nach einem der vorhergehenden Ansprüche, **dadurch gekennzeichnet, dass** eine absolute Feuchtigkeit $\theta$ eines zu untersuchenden Materials (34) unter Verwendung eines NMR-Messgeräts (10), welches nicht identisch sein muss mit dem in Anspruch 1 genannten NMR-Messgerät, mittels zumindest den Verfahrensschritten:

• Spezifizieren des zu untersuchenden Materials (34), insbesondere unter Verwendung einer Eingabevorrichtung (14) des NMR-Messgeräts (10);
• Erfassen der NMR-Messgröße A von dem zu untersuchenden Material (34) mittels des NMR-Messgeräts (10);
• Bereitstellen der ermittelten Kalibriervorschrift in Abhängigkeit des spezifizierten Materials (34);
• Ermitteln der absoluten Feuchtigkeit $\theta$ unter Verwendung des in der Kalibriervorschrift spezifizierten funktionellen Zusammenhangs zwischen der erfassten NMR-Messgröße A des zu untersuchenden Materials (34) und einer in dem untersuchten Material (34) enthaltenen Feuchtigkeit $\theta$;
ermittelt wird.

8. Verfahren nach Anspruch 7, **dadurch gekennzeichnet, dass** die ermittelte absolute Feuchtigkeit $\theta$ des untersuchten Materials (34) unter Verwendung einer Ausgabevorrichtung (16) des NMR-Messgeräts (10) ausgegeben wird.

9. NMR-Messgerät (10), insbesondere handgehaltenes NMR-Messgerät, mit zumindest einem NMR-Sensor (24), einer Steuervorrichtung (26) zur Steuerung des NMR-Messgeräts (10) und zur Auswertung einer NMR-Messgröße A aus einem mittels des NMR-Sensors (24) erfassten NMR-Messsignals, **dadurch gekennzeichnet, dass** die Steuervorrichtung (26) des NMR-Messgeräts (10) zur Durchführung des Verfahrens nach einem der Ansprüche 1-8 eingerichtet ist.

**Claims**

1. Method for determining a calibration specification for use with an NMR measuring device (10), the calibration specification specifying a functional relationship between an NMR measurement variable A, which can be determined using the NMR measuring device (10), of a material (34) to be analysed and a humidity $\theta$ contained in the material (34) to be analysed, **characterized by** at least the following method steps carried out by the NMR measuring device (10) or on a computer:

• providing a relaxation curve $s(t,\theta_{ref})$ of the material (34) having a known humidity $\theta_{ref}$;
• determining a relaxation time distribution $\rho(\theta_{ref})$ from the relaxation curve $s(t,\theta_{ref})$ provided;
• determining an approximated relaxation time distribution $\rho(\theta_i)$ relating to at least one humidity $\theta_i$, with $\theta_i < \theta_{ref}$;
• reconstructing a relaxation curve $s(t,\theta_i)$ from the approximated relaxation time distribution $\rho(\theta_i)$;

• determining an expected NMR measurement variable $A_i$ from the reconstructed relaxation curve $s(t,\theta_i)$ for the humidity $\theta_i$;
• determining the calibration specification as a function $\theta(A)$ describing the humidity $\theta$ as a function of the NMR measurement variable A.

2. Method according to Claim 1, **characterized in that** the relaxation curve $s(t,\theta_{ref})$ provided is provided as a transverse relaxation curve.

3. Method according to either of the preceding claims, **characterized in that** the known humidity $\theta_{ref}$ is at least 50%, preferably at least 70%, particularly preferably at least 90% of a saturation humidity of the material (34).

4. Method according to any one of the preceding claims, **characterized in that** the relaxation time distribution $\rho(\theta_{ref})$ is determined by an inverse Laplace transform from the relaxation curve $s(t,\theta_{ref})$ provided.

5. Method according to any one of the preceding claims, **characterized in that** the approximated relaxation time distribution $\rho(\theta_i)$ relating to at least one humidity $\theta_i$, with $\theta_i < \theta_{ref}$, is calculated by multiplying the relaxation time distribution $\rho(\theta_{ref})$ by a Heaviside step function $H(\tau_c(\theta_i)-\tau)$, where $\tau_c(\theta_i)$ is selected in such a way that an integral $s(\theta_i) = \int\rho(\tau,\theta_i)dt$ is less than $s(t,\theta_{ref})$ by a fraction $1 - \theta/\theta_{ref}$.

6. Method according to any one of the preceding claims, **characterized in that**, in a further method step, approximated relaxation time distributions $\rho(\theta_i)$ relating to a multiplicity i of humidities $\theta_i$, with $\theta_i < \theta_{ref}$, are calculated, in particular relating to more than 3, preferably relating to more than 5, particularly preferably relating to more than 10 humidities $\theta_i$, with $\theta_i < \theta_{ref}$.

7. Method according to any one of the preceding claims, **characterized in that** an absolute humidity $\theta$ of a material (34) to be analysed is determined using an NMR measuring device (10), which need not be identical to the NMR measuring device specified in Claim 1, by means of at least the following method steps:

• specifying the material (34) to be analysed, in particular by using an input apparatus (14) of the NMR measuring device (10);
• recording the NMR measurement variable A of the material (34) to be analysed, by means of the NMR measuring device (10);
• providing the determined calibration specification as a function of the specified material (34);
• determining the absolute humidity $\theta$ by using the functional relationship, specified in the calibration specification, between the recorded NMR measurement variable A of the material (34) to be analysed and a humidity $\theta$ contained in the material (34) analysed.

8. Method according to Claim 7, **characterized in that** the absolute humidity $\theta$ which has been determined for the material (34) analysed is output by using an output apparatus (16) of the NMR measuring device (10).

9. NMR measuring device (10), in particular handheld NMR measuring device, having at least an NMR sensor (24) and a control apparatus (26) for controlling the NMR measuring device (10) and for evaluating an NMR measurement variable A from an NMR measurement signal recorded by means of the NMR sensor (24), **characterized in that** the control apparatus (26) of the NMR measuring device (10) is adapted to carry out the method according to any one of Claims 1-8.

**Revendications**

1. Procédé permettant de déterminer une règle d'étalonnage à utiliser avec un appareil de mesure RMN (10), dans lequel la règle d'étalonnage spécifie une relation fonctionnelle entre une grandeur de mesure RMN A, pouvant être déterminée par l'appareil de mesure RMN (10), d'un matériau à examiner (34) et une humidité $\theta$ contenue dans le matériau à examiner (34),
**caractérisé par** au moins les étapes de procédé suivantes exécutées par l'appareil de mesure RMN (10) ou sur un ordinateur

• fournir une courbe de relaxation $s(t,\theta_{ref})$ du matériau (34) de l'humidité connue $\theta_{ref}$ ;
• déterminer une distribution de temps de relaxation $\rho(\theta_{ref})$ à partir de la courbe de relaxation fournie $s(t,\theta_{ref})$ ;
• déterminer une distribution de temps de relaxation approximative $\rho(\theta_i)$ pour au moins une humidité $\theta_i$ où $\theta_i < \theta_{ref}$ ;
• reconstruire une courbe de relaxation $s(t,\theta_i)$ à partir de la distribution de temps de relaxation approximative $\rho(\theta_i)$ ;
• déterminer une grandeur de mesure RMN attendue $A_i$ à partir de la courbe de relaxation reconstruite $s(t,\theta_i)$ pour l'humidité $\theta_i$ ;
• déterminer la règle d'étalonnage comme une fonction $\theta(A)$ de l'humidité $\theta$ en fonction de la grandeur de mesure RMN A.

2. Procédé selon la revendication 1, **caractérisé en ce que** la courbe de relaxation $s(t,\theta_{ref})$ fournie est fournie sous la forme d'une courbe de relaxation transversale.

3. Procédé selon l'une quelconque des revendications précédentes, **caractérisé en ce que** l'humidité connue $\theta_{ref}$ correspond à au moins 50 %, de préférence à au moins 70 %, de manière particulièrement préférée à au moins 90 % d'une humidité de saturation du matériau (34) .

4. Procédé selon l'une quelconque des revendications précédentes, **caractérisé en ce que** la distribution de temps de relaxation $\rho(\theta_{ref})$ est déterminée par une transformation de Laplace inverse à partir de la courbe de relaxation $s(t,\theta_{ref})$ fournie.

5. Procédé selon l'une quelconque des revendications précédentes, **caractérisé en ce que** la distribution de temps de relaxation approximative $\rho(\theta_i)$ est calculée pour au moins une humidité $\theta_i$, où $\theta_i < \theta_{ref}$, en multipliant la distribution de temps de relaxation $p(\theta_{ref})$ par une fonction discontinue de Heaviside $H(\tau_c(\theta_i)-\tau)$, où $\tau_c(\theta_i)$ est sélectionné de telle sorte qu'une intégrale $s(\theta_i) = \int\rho(\tau,\theta_i)d\tau$ devient inférieure à $s(t,\theta_{ref})$ d'une fraction $1 - \theta/\theta_{ref}$.

6. Procédé selon l'une quelconque des revendications précédentes, **caractérisé en ce que** dans une autre étape de procédé supplémentaire, des distributions de temps de relaxation approximatives $\rho(\theta_i)$ sont calculées pour une pluralité i d'humidités $\theta_i$, où $\theta_i < \theta_{ref}$, en particulier pour plus de 3, en particulier pour plus de 5, de manière particulièrement préférée pour plus de 10 humidités $\theta_i$, où $\theta_i < \theta_{ref}$.

7. Procédé selon l'une quelconque des revendications précédentes, **caractérisé en ce qu'**une humidité absolue $\theta$ d'un matériau à examiner (34) en utilisant un appareil de mesure RMN (10) qui n'est pas nécessairement identique à l'appareil de mesure RMN mentionné à la revendication 1, est déterminée au moyen au moins des étapes de procédé consistant à :

   • spécifier le matériau à examiner (34), en particulier en utilisant un dispositif d'entrée (14) de l'appareil de mesure RMN (10) ;
   • détecter la grandeur de mesure RMN A du matériau à examiner (34) au moyen de l'appareil de mesure RMN (10) ;
   • fournir la règle d'étalonnage déterminée en fonction du matériau spécifié (34) ;
   • déterminer l'humidité absolue $\theta$ en utilisant la relation fonctionnelle spécifiée dans la règle d'étalonnage entre la grandeur de mesure RMN A détectée du matériau à examiner (34) et une humidité $\theta$ contenue dans le matériau à examiner (34).

8. Procédé selon la revendication 7, **caractérisé en ce que** l'humidité absolue $\theta$ déterminée du matériau examiné (34) est sortie en utilisant un dispositif de sortie (16) de l'appareil de mesure RMN (10).

9. Appareil de mesure RMN (10), en particulier appareil de mesure RMN portatif, comprenant au moins un capteur RMN (24), un dispositif de commande (26) pour commander l'appareil de mesure RMN (10) et pour évaluer une grandeur de mesure RMN A à partir d'un signal de mesure RMN détecté au moyen du capteur RMN (24), **caractérisé en ce que** le dispositif de commande (26) de l'appareil de mesure RMN (10) est conçu pour exécuter le procédé selon l'une quelconque des revendications 1 à 8.

20

12

16,16'

14,14'

10

18

34

300

Figur 1

Figur 2

Figur 3

Figur 4

200

↓

202

↓

204

↓

206

↓

208

Figur 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014218375 A1

- CN 106124552 A